# EUROPEAN PATENT SPECIFICATION

(11) **EP 4 075 196 B1**
(45) Date of publication and mention of the grant of the patent: **02.08.2023**
(21) Application number: 21020205.7
(22) Date of filing: 14.04.2021
(51) Int. Cl.: G03F 7/00, G03F 7/027, G03F 7/031, G03F 7/16, G03F 7/20, G03F 7/32, G03F 7/40

(54) **PHOTOLITHOGRAPHIC PREPARATION OF A CIRCUIT BOARD USING A PHOTO- RESIST BASED ON POLY(METH)ACRYLATE) ORGANOGELS**
PHOTOLITHOGRAPHISCHE HERSTELLUNG EINER LEITERPLATTE UNTER VERWENDUNG EINES PHOTOLACKS AUF BASIS VON POLY(METH)ACRYLAT-ORGANOGELEN
PRÉPARATION PHOTOLITHOGRAPHIQUE D'UNE CARTE DE CIRCUIT À L'AIDE D'UN PHOTORÉSISTE À BASE D'ORGANOGELS DE POLY (METH) ACRYLATE

(43) Date of publication of application: 19.10.2022
(73) Proprietor: Karlsruher Institut für Technologie, 76131 Karlsruhe (DE)
(72) Inventor: Pavel, Levkin, 76344 Eggenstein-Leopoldshafen (RU); Scheiger, Johannes, 76137 Karlsruhe (DE); Shuai, Li, 76344 Eggenstein-Leopoldshafen (DE)

(56) References cited:
- EP-A1- 3 502 779
- FERTIER LAURENT ET AL: "The use of renewable feedstock in UV-curable materials - A new age for polymers and green chemistry", PROGRESS IN POLYMER SCIENCE, PERGAMON PRESS, OXFORD, GB, vol. 38, no. 6, 4 January 2013 (2013-01-04), pages 932-962, XP028533437, ISSN: 0079-6700, DOI: 10.1016/J.PROGPOLYMSCI.2012.12.002
- LEE S H ET AL: "Three-dimensional micropatterning of bioactive hydrogels via two-photon laser scanning photolithography for guided 3D cell migration", BIOMATERIALS, ELSEVIER, AMSTERDAM, NL, vol. 29, no. 20, 1 July 2008 (2008-07-01), pages 2962-2968, XP022647937, ISSN: 0142-9612, DOI: 10.1016/J.BIOMATERIALS.2008.04.004 [retrieved on 2008-04-22]
- DASHAN I ET AL: "Versatile light-responsive organogels: evaluation of their dye releasing and photoinitiation behaviors", JOURNAL OF POLYMER SCIENCE, PART A: POLYMER CHEMISTRY WILEY USA, vol. 57, no. 12, 23 April 2019 (2019-04-23), pages 1275-1282, XP002804332, ISSN: 0887-624X, DOI: 10.1002/POLA.29383

## Description

The invention relates to a process for the photolithographic preparation of a circuit board using a photoresist based on poly((meth)acrylate) organogels.

Photolithography is one of the key processing steps in electronics today. The purpose of the process of photolithography and microfabrication is to create structures on the micron scale or even smaller. The process has been optimized to produce these smaller and smaller structures since it was invented, providing today's technology to become faster and more reliable.

The technology also provided technological breakthroughs such as transistors and most integrated circuits today. Photolithography is also known as essential building block for the production of sensors and actuators in Micro Electro Mechanical Systems (MEMS), including fabrication and characterization of accelerometers and advanced materials such as ferroelectrets and piezoe-lectrics for energy harvesters. The process of photolithography is extremely flexible when designing geometric patterns; any pattern can be achieved depending on the technology available down to the nanometer scale. Also there has been great focus on three-dimensional microstructures for various microsystems (R. Balma et al., Proceedings of the 2011 ASEE NC & IL/IN Section Conference, https://www.semanticscholar.org/paper/Development-of-Thin-Film-Photolithography-Process-%3A-Balma-Petsch/4cb5be556d2d7a82355915a21b173182c6d40917) .

A printed circuit board mechanically supports and electrically connects electrical or electronic components using conductive tracks, pads and other features etched from one or more sheet layers of, for example, copper laminated onto and/or between sheet layers of a non-conductive substrate. (https://en.wikipedia.org/wiki/Printed_circuit_board) .

Thin film deposition is the first step in wet etches in photolithography. The process involves producing a conductive coating - as conductor layer - on a suitable substrate.

Substrates supporting a conductor layer are commercially available. As an example, a conductive metal layer can be applied on a substrate, e.g., via lamination (https://de.rs--und-leiterplatten-prototyping/leiterplatten/kupferkaschierte-leiterplatten-tinte-beschichtet; https://www.printedcir-cuits.com/printed-circuits-materials/). A metallic coating of the substrate is also possible by electrochemical means, if the substrate is conductive or has a conductive layer spudder coated onto the substrate (https://en.wikipedia.org/wiki/Photolithography) .

The majority of single-sided and double-sided through-hole printed circuit boards are produced photochemically. The tracks are usually produced photo-lithographically by applying a thin layer of a light-sensitive photoresist to a surface that is fully coated with a conductive layer. After exposing the photoresist through a photomask with the desired board layout, either the exposed or unexposed portions of the resist are soluble in a suitable developer solution/solvent, depending on the photoresist used, and are removed. If the circuit board treated in this way is brought into a suitable etching solution (e.g., iron(III) chloride or sodium persulfate dissolved in water, respectively, or a mixture of hydrochloric acid and hydrogen peroxide), only the exposed part of the surface bearing the conductive layer is attacked; the parts covered by the photoresist remain intact, because the resist is resistant to the etching solution (https://de.wikipedia.org/wikiA/Leiterplatte). Another etching method commonly used for the preparation of circuit boards is plasma etching (https://en.wikipedia.org/wiki/Plasma_etching).

Metals commonly used for printed circuit boards are Cu, Ni, Ag, Au, Cr, Mo or Al (D. Li et al., Journal of Materials Chemistry 2009, 19, 3719-3724; I. E. Stewart et al., ACS applied materials & interfaces 2017, 9, 1870-1876; H. Wu et al., Nature Nanotech 2013, 8, 421-425).

Other suitable conductive materials used for circuit boards are polysilicon or semiconductor materials like silicon-germanium, gallium arsenide or gallium nitride (https://globalsmt.net/technology_news/wafer-bonding-integrate-silicon-gallium-arsenide-gallium-nitride/).

Photoresist coating techniques play a major role in wet etches in photolithography. There are several different coating methods and each specific to certain applications. Some photoresist coating options are spray coating, spin coating, roller coating and dip coating. Multiple factors have to be considered depending on the application type, which include film thickness, coating time, size, substrate texture and cost. Spray coating is inexpensive and can work with all sized and shaped substrates. Spin coating utilizes centripetal forces to spread the resist across the substrate. The process holds a high yield in a flat surface covering but is almost ineffective in three dimensional structures (R. Balma et al., Proceedings of the 2011 ASEE NC & IL/IN Section Conference, https://www.semanticscholar.org/paper/Development-of-Thin-Film-Photolithography-Process-%3A-Balma-Petsch/4cb5be556d2d7a82355915a21b173182c6d40917).

A common photoresist for photolithography in microelectronics and micromechanics is Novolak, a low molecular weight polymer derived from phenols and formaldehyde, combined with photosensitive substances, such as Diazonaphthoquinone. Novolak is usually spun onto a substrate through a spin coater and resist thicknesses down to a few µm can be achieved. Novolak is unsuitable for thicker layers (https://www.chemie.de/lexikon/Novolak.html).

(Meth)acrylate monomers can be polymerized under various polymerization techniques, like Radical Polymerization or Controlled Radical Polymerization, such as Reversible Addition-Fragmentation Chain-Transfer Polymerization (RAFT), ATRP (Atom Transfer Radical Polymerization), NMP (Nitroxide-Mediated Radical Polymerization) and others (Théato et al., Journal of Polymer Science: Part A: Polymer Chemistry, 2008, Vol. 46, 6677-6687).

Radical Polymerization is a chain growth polymerization in which a polymer forms by the successive addition of monomer units to a propagating radical chain. In Free Radical Polymerization usually separate radical initiators are used. Following its generation, the initiating free radical adds (non-radical) monomer units, thereby growing the polymer chain. Radical Polymerization is a key synthesis route for obtaining a wide variety of different polymers and material composites. The relatively non-specific nature of free-radical chemical interactions makes this one of the most versatile forms of polymerization available and allows facile reactions of polymeric free-radical chain ends and other chemicals or substrates (Rudin et al., The Elements of Polymer Science & Engineering (Third Edition), 2013, 341-389).

Controlled Radical Polymerization methods enable the straightforward synthesis of polymeric materials from a wide range of different monomers featuring narrow molar mass distributions as well as low dispersity and allow for a good control over the polymerization itself. Reversible Addition-Fragmentation Chain-Transfer Polymerization makes use of a chain transfer agent in the form of a thiocarbonylthio compound (or similar) to afford control over the generated molecular mass and dispersity during Radical Polymerization. Common chain transfer agents for RAFT are dithioesters, dithiocarbamates, xanthates or trithiocarbonates, such as 4-cyano-4-[(dodecylsulfanylthiocarbonyl)sulfanyl]pentanoic acid or 2-(dodecylthiocarbono-thioylthio)-2-methylpropionic acid (Matyjaszewski et al., Materials Today 2005, 8, 26-33; G. Moad et al., Chem. Asian J. 2013, 8, 1634-1644).

Radical initiators are substances that can produce radical species under mild conditions (photo-induced or thermally induced) and promote radical reactions. These substances generally possess bonds that have small bond dissociation energies and react with monomers and/or oligomers to initiate polymer chain growth. Typical examples are molecules with a nitrogen-halogen bond, azo compounds, and organic and inorganic peroxides (J. March, 1985, Advanced Organic Chemistry: Reactions, Mechanisms, and Structure (3rd ed.), New York: Wiley; M. B. Smith, J. March, 2007, Advanced Organic Chemistry: Reactions, Mechanisms, and Structure (6th ed.), New York: Wiley-Interscience).

Carbaugh *et al.* describe a technique for positive-tone or negative-tone conventional photolithography with ordinary poly(methyl methacrylate) (PMMA). The process uses a commercially available photoactive cross-linking agent, Irgacure 651, to induce PMMA chains to cross-link under UV-A exposure. This technique can be used for patterning structures and creating topographic structures with desired height variations and with a resist thickness in the range of hundreds of nanometers. The resist inherits the properties of its base material i.e. PMMA, thus it is less thermally stable (usable up to about 110 °C) but is transparent and easily removed after use with a simple rinse in acetone. However, PMMA has a rather low intrinsic photodegradability efficiency, as in a film of a homopolymer such as PMMA, the polymer chains are close together, favoring side reactions during the photodegradation process (Carbaugh et al., Semicond. Sci. Technol. 2016, 31, 025010).

Organogels are polymeric, three-dimensional networks swollen in organic solvents/liquids. These networks can be formed either via self-assembly of low-molecular weight gelators or polymerization reactions. Analogue to hydrogels, cross-linking can be achieved chemically (covalent bonding) or physically (e.g. entanglement, π-stacking) (https://en.wikipedia.org/wiki/Organogels) .

Organogels can possess unique and interesting properties such as a high hydrophobicity, high freeze tolerance or low adhesion. As such, they are candidates for applications as encapsulants, drug and nutrition carriers, actuators, freeze tolerant elastomers, solid edible oils, slippery surfaces (self-cleaning, anti-waxing, anti-bacterial, anti-biofouling) or in oil-water separation. To design functional organogel materials, strategies to control their shape and surface structure are required. The surface texture of organogels influences their wettability and optical properties. However, fabrication of structured organogels is not trivial, since established methods for hydrogels cannot be employed readily. For example, the cross-linked polydimethylsiloxane (PDMS) molds utilized in soft-lithography swell in hydrophobic solvents and are thus prone to deformation.

EP3502779 A1 describes a photodegradable poly((meth)acrylate) hydrogel or organogel, a method for degrading the photodegradable hydrogel or organogel for manufacturing a patterned article, as well as the use of a thus obtained patterned article in mi-croengineering, e.g. for three-dimensional cell culturing, for drug delivery, or for tissue-engineering.

The objective technical problem was to provide a photoresist based on poly((meth)acrylate) organogels, where the organogel photoresist should be used in a photolithographic manufacturing process for a circuit board, in which the energy input for photodegradation of the photoresist and the necessary irradiation time should be reduced, a cheap energy source for irradiation should be applicable and a developer solvent should not be needed any more.

The objective technical problem is solved by the embodiments characterized in independent claim 1. Preferred embodiments can be found in the dependent claims.

According to the invention, the preparation of a photoresist based on poly((meth)acrylate) organogels is realized by polymerization or copolymerization of alkyl (meth)acrylate monomers, using a suitable cross-linker and a suitable organic solvent, such as an aliphatic alcohol with a carbon chain length from C4 - C10 or an n-alkane with a carbon chain length from C8 - C12. The thus obtained organogel photoresist is subsequently used in a photolithographic manufacturing process for the preparation of a circuit board. The term organogel photoresist means a photoresist composed of an organogel.

The method according to the invention comprises the following steps:
A) Providing at least one alkyl (meth)acrylate, an aliphatic alcohol with a carbon chain length from C4 - C10 or an n-alkane with a carbon chain length from C8 - C12 as organic solvent, a radical initiator and a cross-linker;
B) Preparing a reaction mixture with the reactants and the solvent from step A) by mixing the least one alkyl (meth)acrylate with the aliphatic alcohol or the n-alkane, and adding to this mixture the radical initiator and the cross-linker;
C) Applying the reaction mixture from step B) to a surface of a substrate, wherein the surface carries a conductor layer.
D) Initiating the formation of radicals and (co)polymerization of the alkyl (meth)acrylate monomers under supply of heat, near-infrared (NIR) or ultraviolet-visible (UV-Vis) radiation onto the surface of the substrate from step C);
E) Placing a photomask on top of the photoresist from step D);
F) Irradiating the photomask from step E) with UV light;
G) Removing the photomask after step F) and rinsing the substrate with water or an organic solvent such as methanol or ethanol;
H) Etching the substrate after step G) in an etching solution or etching the surface of the substrate by plasma etching;
I) Removing the remaining organogel photoresist after step H) by irradiation with UV light or mechanical abrasion and exposing a conductor track.

The at least one alkyl (meth)acrylate in step A) is selected from, e.g., methyl (meth)acrylate, ethyl (meth)acrylate, propyl (meth)acrylate, isopropyl (meth)acrylate, butyl (meth)acrylate, isobutyl (meth)acrylate, tert-butyl (meth)acrylate, pentyl (meth)acrylate, hexyl (meth)acrylate, heptyl (meth)acrylate, octyl (meth)acrylate, nonyl (meth)acrylate, decyl(meth)acrylate, undecyl (meth)acrylate, dodecyl (meth)acrylate (lauryl methacrylate), tridecyl (meth)acrylate, tetradecyl (meth)acrylate, pentadecyl (meth)acrylate or hexadecyl (meth)acrylate.

In a preferred embodiment, in step A) is selected at least one medium-chain alkyl (meth)acrylate and at least one short-chain alkyl (meth)acrylate. As defined herein, a medium-chain alkyl (meth)acrylate has an alkyl chain length of C = 6 - 16, a short-chain alkyl (meth)acrylate has an alkyl chain length of C = 1 - 5.

The at least one medium-chain alkyl (meth)acrylate in step A) is selected from, e.g., hexyl (meth)acrylate, heptyl (meth)acrylate, octyl (meth)acrylate, nonyl (meth)acrylate, decyl(meth)-acrylate, undecyl (meth)acrylate, dodecyl (meth)acrylate (lauryl (meth)acrylate), tridecyl (meth)acrylate, tetradecyl (meth)acrylate, pentadecyl (meth)acrylate or hexadecyl (meth)acrylate. In a more preferred embodiment the at least one medium-chain alkyl (meth)acrylate is dodecyl (meth)acrylate (lauryl (meth)acrylate) .

The at least one short-chain alkyl (meth)acrylate in step A) is selected from e.g. methyl (meth)acrylate, ethyl (meth)acrylate, propyl (meth)acrylate, isopropyl (meth)acrylate, butyl (meth)acrylate, isobutyl (meth)acrylate, tert-butyl (meth)acrylate or pentyl (meth)acrylate.

In a more preferred embodiment the at least one short-chain alkyl (meth)acrylate is butyl (meth)acrylate.

In a preferred embodiment the molar ratio of the at least one short-chain alkyl (meth)acrylate to the at least one medium-chain alkyl (meth)acrylate based on the total molar proportion of alkyl (meth)acrylates in the reaction mixture from step B) is 2.5:1 - 1.5:1.

(Meth)acrylates with medium-length aliphatic ester groups show less of the undesired Trommsdorf effect (i.e. auto-acceleration of the polymerization, https://de.wikipedia.org/wiki/ Trommsdorff-Effekt) and are useful for a reaction control. However, the viscosity and melting points of medium-chain (meth)acrylates are higher than those of short-chain (meth)acrylates, which makes handling/storing slightly harder. According to the invention it is important that the gel polymerizes in the exact shape of the mold and possesses a smooth surface, without any crumbling or deformation of the gel, which can happen if the reaction auto-accelerates. Thus, the copolymerization of at least one short-chain alkyl (meth)acrylate with at least one medium-chain alkyl (meth)acrylate is beneficial.

According to the invention, the organic solvent provided in step A) is chosen from an aliphatic alcohol with a carbon chain length from C4 - C10 or the organic solvent is chosen from an *n-*alkane with a carbon chain length from C8 - C12.

In a preferred embodiment the organic solvent is chosen from e.g., 1-butanol, *tert*-butanol, 1-pentanol, 1-hexanol, 1-heptanol, 1-octanol, 1-nonanol, or the organic solvent is chosen from, e.g., 1-nonane, 1-decane or 1-undecane.

In a more preferred embodiment the organic solvent provided in step A) is 1-nonanol.

According to the invention, the cross-linker provided in step A) is selected from poly(propylene) glycol dimethacrylate (PPGDMA), ethylene glycol dimethacrylate (EGDMA), *N*,*N*'-methylenebisacrylamide (MBA), poly(ethylene glycol) dimethacrylate, selected from PEG72DMA to PEG20000DMA, or poly(ethylene glycol) diacrylate, selected from PEG72DA to PEG20000DA.

In a preferred embodiment the cross-linker is selected from poly (propylene) glycol dimethacrylate (PPGDMA).

The mole fraction of the cross-linker used in the reaction mixture from step B) is from 0.10 to 20 % based on the total amount of the monomer units and the cross-linker.

According to the invention, the radical initiator provided in step A) is selected from azo compounds such as AIBN (Azobisisobutyronitrile), 2,2'-Azobisisoheptonitrile, Dimethyl 2,2'-azo-bis(2-methylpropionate) (AIBME), Vazo 52 (2,2'-azobis(2,4-dime-thylpentanenitrile)), Vazo 67 (2,2'-azobis(2-methylbutaneni-trile))or Vazo 88 (1,1'-azobis(cyclohexanecarbonitrile)), or organic peroxides, like Dibenzoyl peroxide or Di-*tert*-butyl peroxide, or Irgacure 81.

In a preferred embodiment the radical initiator is AIBN.

After preparing a reaction mixture in step B), the reaction mixture is applied in step C) to a conductive surface of a substrate, the conductive surface forming a conductor layer. In a preferred embodiment the reaction mixture is applied to the conductive surface by pipetting, pouring, spray coating, spin coating or roller coating.

The substrate in step C) is chosen from glass, quartz, alcohol resistant thermosets (Chemical Resistance of Thermosets, 1st Edition, E. Baur et al., Plastics Design Library 2018, https://www.elsevier.com/books/chemical-resistance-of-thermosets/baur/978-0-12-814480-0; https://www.woodlandplas-tics.com/blog/index.php/chemical-resistance-in-thermosets/), polyimides (https://de.wikipedia.org/wiki/Polyimide), glass-epoxy composites such as FR-4, FR-5 or FR-6 (https://en.wikipe-dia.org/wiki/FR-4; https://en.wikipedia.org/wiki/Printed_circuit_board#Common_substrates), or phenolic paper like FR-1 and FR-2 (https://en.wikipedia.org/wiki/FR-2; https://en.wikipedia.org/wiki/Phenolic_paper).

Substrates supporting a conductor layer are commercially available.

According to the invention the conductor layer comprises a conductive material like at least one metal, polysilicon or at least one semiconductor material like silicon-germanium, gallium arsenide or gallium nitride.

In one embodiment of the invention the conductor layer comprises at least one metal. In a preferred embodiment the at least one metal is chosen from Cu, Ni, Ag, Au, Cr, Mo or Al.

In a more preferred embodiment the at least one metal is Cu. Depending on the respective electrode potential, also at least two metals can be chosen for the metal conductor layer.

The conductor layer in step C) has a thickness of 17.5 - 70 µm.

In step D), a polymerization reaction is started thermally, pho-tothermally, or photochemically with the application of heat, near-infrared (NIR) or ultraviolet-visible (UV-Vis) radiation onto the substrate surface bearing a conductive layer covered with the reaction mixture. The polymerization method in step D) is not particularly limited. Thus, any known polymerization method can be used, like Radical Polymerization or Controlled Radical Polymerization, such as Reversible Addition-Fragmentation Chain-Transfer Polymerization (RAFT), ATRP (Atom Transfer Radical Polymerization) or NMP (Nitroxide-Mediated Radical Polymerization).

For RAFT polymerization the further addition of a chain transfer agent like dithioesters, dithiocarbamates, xanthates or trithiocarbonates, such as 4-cyano-4-[(dodecylsulfanylthio-carbonyl)sulfanyl]pentanoic acid or 2-(dodecylthiocarbonothi-oylthio)-2-methylpropionic acid, is necessary. For ATRP polymerization the further addition of initiators like brominated alkanes, chlorinated alkanes, catalyst like Cu^{I}/Cu^{II}-Br, Cu^{I}/Cu^{II}-Cl, Cu^{I}/Cu^{II}-I and ligands like 2,2'-bipyridine, tris(2-dimethylaminoethyl)amine (Me6TREN), 1,1,4,7,7-pentamethyl-diethylenetriamine (PMDETA), tris(2-pyridylmethyl)amine (TPMA), are necessary. For NMP polymerization the further addition of initiators like dibenzoyl peroxide (BPO), nitroxides like 2,2,6,6-tetramethyl-1-piperidinyloxy (TEMPO), are necessary.

In a preferred embodiment the (co)polymer in step D) is produced by thermally-induced Radical Polymerization or photo-induced Radical Polymerization (https://en.wikipedia.org/wiki/Radical_polymerization).

In a preferred embodiment the reaction in step D) is performed under thermal initiation at 60 - 80 °C for 30 - 90 min or the reaction is performed under photochemical initiation with UV-Vis light with a wavelength of 360 - 380 nm, an intensity of 1 - 10 mW/cm² and a duration of 1 - 10 min.

After step D) an organogel photoresist is obtained on the conductive surface of the substrate.

According to the invention the organogel photoresist after step D) has a thickness of 50 - 500 µm.

Optionally the organogel photoresist obtained after step D) is infused multiple times with an excess of an aliphatic alcohol with a carbon chain length from C4 - C10, e.g., 1-butanol, *tert-*butanol, 1-pentanol, 1-hexanol, 1-heptanol, 1-octanol, 1-nonanol, or with an *n*-alkane with a carbon chain length from C8-C12, e.g., 1-nonane, 1-decane or 1-undecane, to extract side products of the polymerization. For this rinsing step, the aliphatic alcohol chosen is the same as the organic solvent chosen in Step A).

In a preferred embodiment of the invention the organogel photoresist obtained after step D) is swollen before step E) on the substrate in the same organic solvent as chosen in step A).

The organic solvent for swelling the organogel photoresist after step D) is chosen from an aliphatic alcohol with a carbon chain length from C4 - C10, e.g., 1-butanol, *tert*-butanol, 1-pentanol, 1-hexanol, 1-heptanol, 1-octanol, 1-nonanol, or from an *n*-alkane with a carbon chain length from C8 - C12, e.g., 1-nonane, 1-decane or 1-undecane. The optional swelling of the organogel photoresist after step D) has the advantage that the photodegradation of the organogel photoresist is more effective and is accelerated.

After swelling the organogel photoresist after step D) the organogel photoresist consists of 60 - 90 wt% (% by weight) of the organic solvent.

The choice of the solvent chosen in step A) and for the optional swelling process after step D) is decisive for the photodegradation of the organogels. This is due to two main factors: (i) the UV absorbance and (ii) the swelling capability of the organic solvent. For a fast photodegradation process, the UV absorbance of the solvent should be low, and it should swell the organogel network strongly. A high UV absorbance of the solvent reduces the effective light intensity available for the photodegradation, whereas insufficient swelling causes the gel network to undergo more side reactions, such as cross-linking, due to lower inter-chain distances within the polymer network. UV-Vis spectra of common solvents were measured and the swelling factor of these solvents in the organogel photoresist networks according to the invention were tested. The swelling factor was defined as the ratio of the swollen organogel photoresist weight (wₛ) divided by the dry weight of the polymer network (w_{d}).

### Table 1:

**Table 1. Properties of solvents investigated for their influence on the photodegradation properties of organogels. Data are given as mean ± standard deviation SD (n=3).**

| Solvent | 1-nonanol | 1-butanol | toluene | PDMS |
|---|---|---|---|---|
| Swelling factor^{a} | 3.78 ± 0.17 | 3.48 ± 0.07 | 15.88 ± 0.37 | 1.02 ± 0.01 |
| UV Transmis-sion^{b} (%) | 19 | 94 | < 1 | 92 |
| Boiling Point (°C) | 214 | 118 | 111 | - |

| | | | | |
|---|---|---|---|---|
| ^{a}Defined as wₛ/w_{d} ^{b}Value at 250 nm | | | | |

It is expected that all primary alcohols with alkyl chains from C4 - C10 and *n*-alkanes with a carbon chain length from C8 - C12 are suitable as solvents for the photodegradation of the organogel photoresist due to their hydrophobicity, low UV absorbance and high boiling point.

It is not possible to use polar alcohols such as ethanol, methanol or *iso*-propanol, since they do not infuse into the non-polar polymer matrix and cause phase separation phenomena, e.g. the surface of the organogel photoresist turns (reversibly) turbid when in contact with polar alcohols such as methanol, ethanol, or *iso*-propanol.

In a preferred embodiment 1-nonanol is used as solvent in step A) and for the optional swelling process after step D) due to its high boiling point, low hazard potential and rather pleasant smell.

The photomask used in step E) is such that a circuit board with conductive tracks with a diameter of 50 - 5000 µm can be prepared.

In a preferred embodiment the photomask is irradiated in step F) with UV-light with a wavelength of 190 - 320 nm and an intensity of 10 - 20 mW/cm² for 1 - 10 min.

In step G) the photomask is removed and the substrate is rinsed with water or an organic solvent such as methanol or ethanol. In step H) the substrate is etched in an etching solution for 30 - 120 min or the surface of the substrate is etched by plasma etching.

Etching solutions are, e.g., selected from an aqueous iron(III) chloride solution, a solution of copper(II) chloride in HCl, a solution of ammonium or sodium persulfate, and mixtures of sulfuric acid and hydrogen peroxide (https://www.seeedstu-dio.com/blog/2017/03/16/pcb-etching/).

For an embodiment in which the conductor layer comprises polysilicon suitable etching solutions are aqueous NH₄F/HF, HNO₃/HF or KOH solutions (https://d1rkab7tlqy5f1.cloudfront.net/TNW/ Afdelingen/Quantum%20Nanoscience/Kavli%20Nanolab%20Delft/Equipment/BOE-HF%20SOP%20Silicon%20Etching.pdf; https://www.micro-chemicals.com/technical_information/silicon_etching.pdf).

In step I) the remaining organogel photoresist is removed by radiation with UV light, or the organogel is removed by mechanical abrasion.

In one embodiment the remaining organogel photoresist is removed by radiation with UV light with a wavelength of 190 - 320 nm, an intensity of 10 - 20 mW/cm² and a duration of 1 - 10 min.

During the photodegradation process according to the invention, the organic solvent of the organogel photoresist network is released and it dissolves the eroded areas of the network. The irradiated areas liquefy. This eliminates the need for a second step, as is usually the case with positive coatings, in which the irradiated polymer must first be removed from the surface with the aid of a developer solvent.

The method according to the invention has the following advantages:
The organogel photoresist according to the invention can be degraded quickly with affordable UV lamps and shows a high intrinsic efficiency of photodegradation when irradiated with UV light. There is no external solvent (developer solvent) required to remove irradiated polymer fragments from the surface of the conductor layer as a further step, since these fragments dissolve into the solvent released upon organogel degradation.

The photoresist obtained by the method of the invention can be used for photographic fabrication processes in the electric industry and semiconductor industry.

The invention is explained in more detail with reference to the following figures, examples of embodiments and descriptions. All the features shown and their combinations are not limited to these figures and examples and their embodiments. Rather, they are to be regarded as representative of further possible embodiments which are not explicitly shown as embodiments and which can be combined in so far as said combination falls under the scope of the invention as defined by the appended claims.
Figure 1:

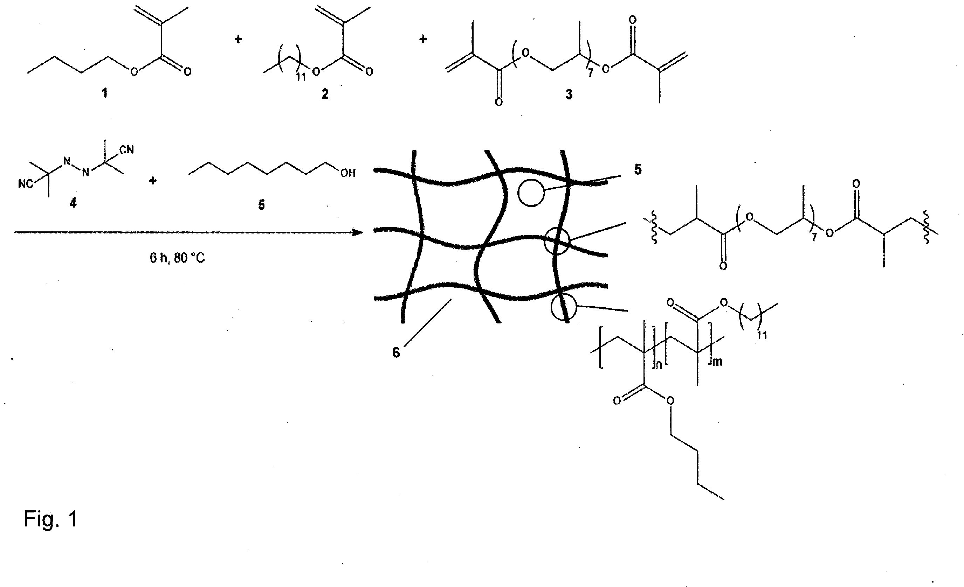

   Figure 1 shows a reaction equation for the synthesis of poly(BMA-*co*-LMA-*co*-PPGDMA) organogel from lauryl methacrylate (LMA) and butyl methacrylate (BMA) monomers with poly(propylene glycol) dimethacrylate (PPGDMA) as a cross-linker. 1 = BMA, 2 = LMA, 3 = PPGDMA, 4 = AIBN, 5 = 1-nonanol, 6 = poly(BMA-*co*-LMA-*co*-PPGDMA).
Figure 2:

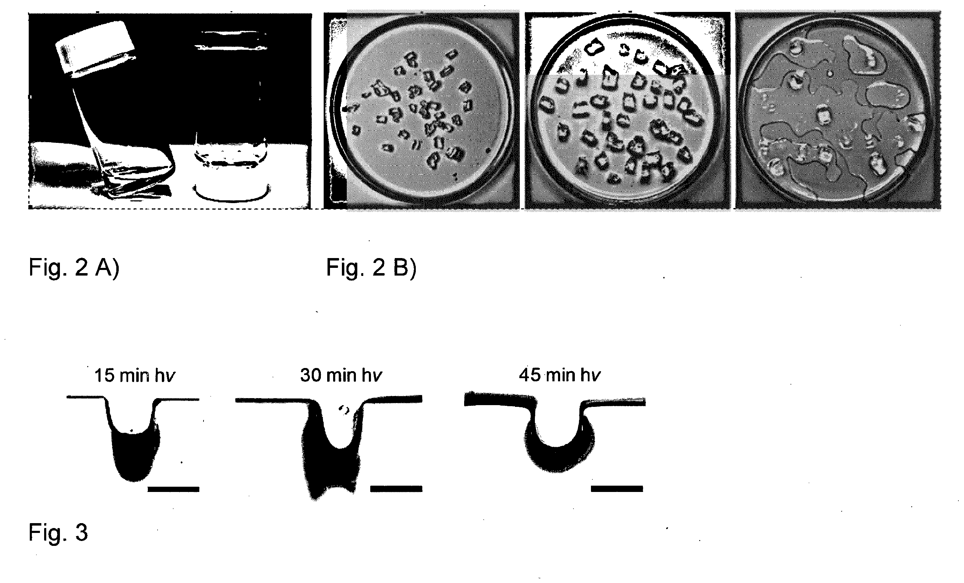

   Figure 2 A) shows an image of the organogel precursor solution (left vial) and the organogel prepared according to example 1 (right vial). Figure 2 B) shows an image of dried organogel pieces (left petri dish), swollen organogel pieces (middle petri dish) and swollen degraded organogel pieces after 30 min of UV photodegradation (right petri dish). The diameter of the glass petri dish was 5 cm. When swollen in 1-butanol or 1-nonanol, the organogels showed inherent photodegradation properties under UV light (Hg bulb, not shown).
Figure 3:
   Figure 3 shows microscopy images of organogel photoresist degradation profiles for different UV irradiation times. The depth of degradation was controllable by the choice of irradiation time. Increasing the UV irradiation time led to an increase in erosion depth. Scale bars are 1 mm.
Figure 4:

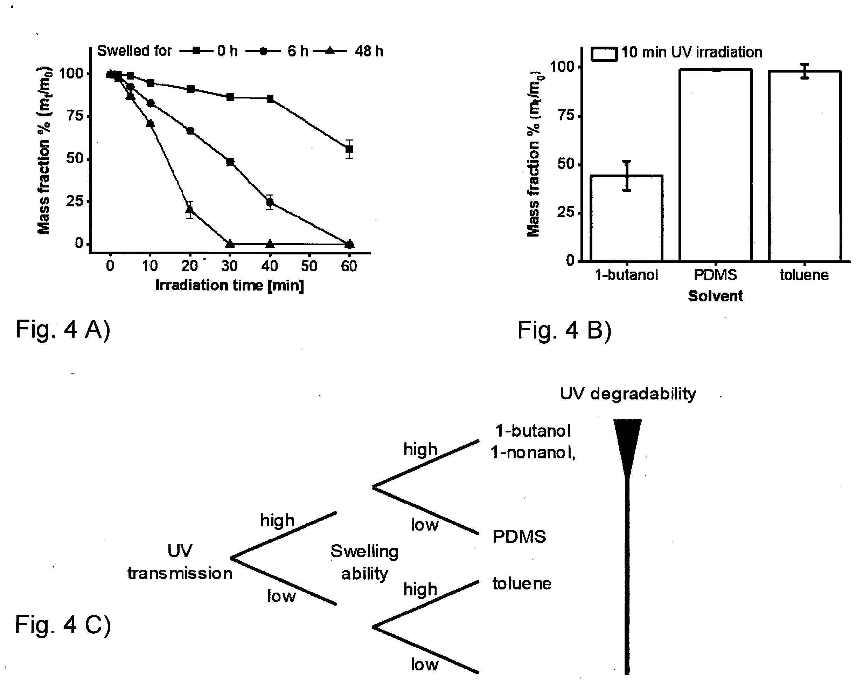

   Figure 4 A) shows the photodegradation speed of poly(BMA-co-LMA-co-PPGDMA) organogels infused in 1-nonanol for 0, 6 and 48 h, within an UV-irradiation time of 60 min. The resulting 1-nonanol content of the organogels was 61, 68, and 76 wt%, respectively. Data are given as mean ± standard deviation SD (n = 4). The y-axis shows the mass fraction mₜ/m₀ in % of the mass of the degraded organogels (mt) relative to their initial mass (m₀).
   Figure 4 B) shows the photodegradation of poly(BMA-*co*-LMA-*co-*PPGDMA) organogels infused with 1-butanol, polydimethylsiloxane (PDMS) and toluene after 10 min of UV light irradiation. The y-axis shows the mass fraction mₜ/ m₀ in % of the mass of the degraded organogels (mt) relative to their initial mass (m₀). Only 1-butanol showed significant photodegradation.
   Figure 4 C) shows a general scheme of solvent properties affecting the organogel photodegradability. Solvents with low UV light transmission or swelling ability inhibit the photodegradation of organogels, whereas high swelling, UV-transmitting solvents such as 1-butanol or 1-nonanol enable photodegradation. PDMS = polydimethylsiloxane.
Figure 5:

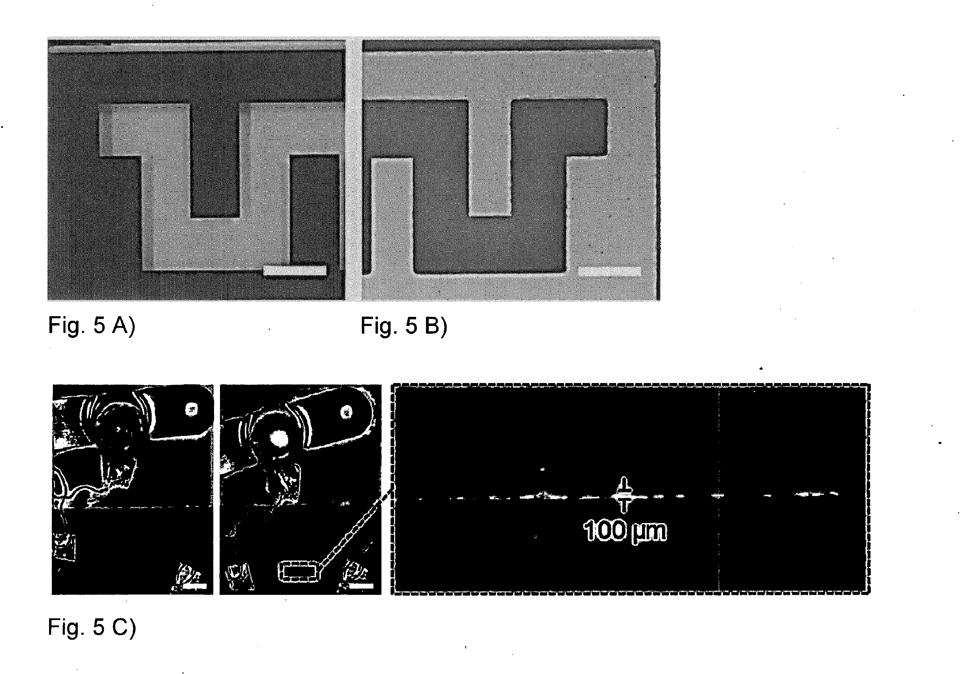

   Figure 5 A) shows an image of a photomask and Figure 5 B) shows the resulting copper layer after using a patterned poly(BMA-*co-*LMA-*co*-PPGDMA) organogel film as positive photoresist. The organogel film was polymerized on top of a copper circuit board with a glass plate on top, resulting in a film thickness of 200 µm. The glass plate was removed and the organogel film was patterned with UV light using the said photomask. Unprotected copper was then removed/etched with 0.5 M aq. FeCl₃ solution, whereas the copper covered by the unirradiated organogel phororesist remained unaffected. Scale bars are 5 mm.
   Figure 5 C) shows a closed circuit formed when a light bulb and a battery (not in the image) were connected via a thin electrically conductive copper line (50 mm length, 100 µm width), which was fabricated with the aid of an poly(BMA-*co*-LMA-*co*-PPGDMA) organogel photoresist. Scale bars are 5 mm.
Figure 6:

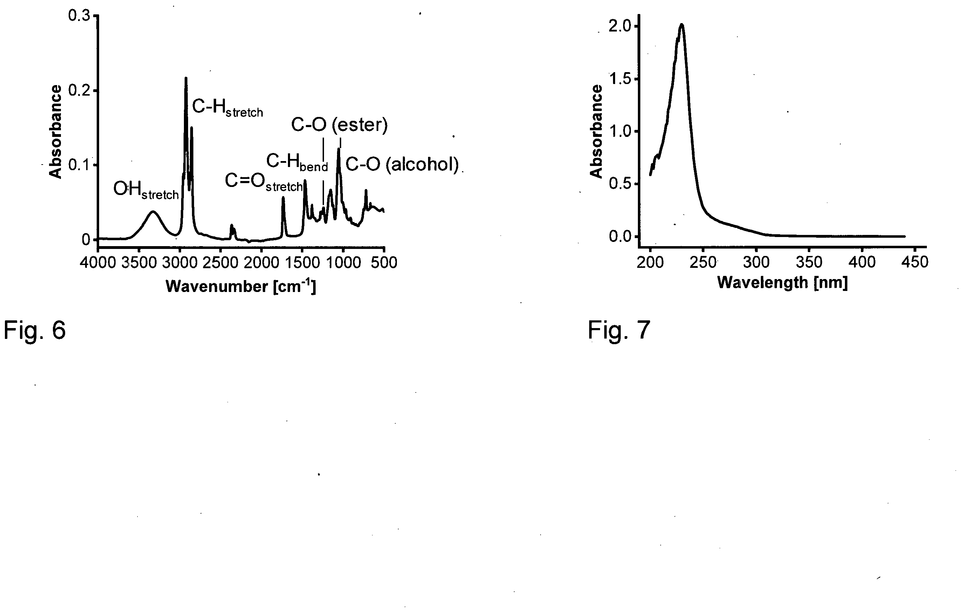

   Figure 6 shows an ATR-FTIR spectrum of a poly(BMA-*co*-LMA-*co-*PPGDMA) organogel (swollen in 1-nonanol). Position and width of relevant peaks: v [cm⁻¹] = 3330 (b, s), 2957 (s), 2924 (vs), 2855 (vs), 1730 (m), 1466 (s), 1379 (m), 1242 (m), 1155 (m), 1057 (s), 721 (m). A strong and broad band around 3330 cm⁻¹ showed the presence of the O-H stretch from 1-nonanol. The different C-H stretching (2957, 2924, 2855 cm⁻¹) and bending vibrations (1466, 1379 cm⁻¹) arose from both poly (BMA-*co*-LMA-*co*-PPGDMA) and 1-nonanol. The absence of lauryl and butyl methacrylate monomers could be concluded from the absence of their characteristic alkene peak at 1640 cm⁻¹. Further, the carbonyl peak was at 1730 cm⁻¹, which is upshifted by 7 cm⁻¹ compared to the starting materials lauryl and butyl methacrylate. This was due to the changed chemical environment of the carbonyl group upon polymerization from a conjugated α-β unsaturated ester to a saturated ester. No nitrile peak (2210 cm⁻¹) indicating the presence of AIBN could be observed. The peaks at 1242 and 1155 cm⁻¹ could be attributed to C-O stretching vibrations of the ester functionalities, whereas the peak at 1057 cm⁻¹ belonged to the bending vibration of the hydroxy group in 1-nonanol.
Figure 7:
   Figure 7 shows an UV Vis spectrum of a poly(BMA-*co*-LMA-*co-*PPGDMA) organogel film (125 pm). The polymer absorbance can be observed starting at around 320 nm. The peak absorbance is at ca. 230 nm, which is presumably due to the ester functionalities in poly(BMA-*co*-LMA-*co*-PPGDMA). The contribution of 1-nonanol is rather small due to the film thickness of the measured sample in contrast to the 1 cm cuvette normally used for obtaining UV Vis spectra.
Figure 8:

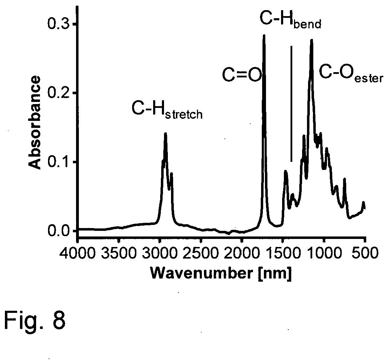

   Figure 8 shows an ATR-FTIR spectrum of a poly(BMA-*co*-LMA-*co-*PPGDMA) organogel photodegraded for 30 min. Position and width of relevant peaks: v [cm⁻¹] = 2958 (m), 2925 (s), 2855 (m), 1726 (vs), 1464 (m), 1381 (w), 1240 (s), 1147 (vs), 966 (s), 748 (m). The degraded organogel solution was precipitated in cold methanol, dried, dissolved in THF and then drop-casted onto a glass plate. The most apparent difference to the spectrum of the unirradiated organogel is the disappearance of characteristic 1-nonanol peaks (O-H_{stretch} and O-H_{bend} at 3330 cm⁻¹ and 1057 cm⁻¹, respectively). Due to the absence of 1-nonanol, the intensity of the aliphatic C-H stretching peaks (2958, 2925, and 2855 cm⁻¹) decreased relative to the intensity of the carbonyl peaks (C=O stretch 1726 cm⁻¹ and C-Oₑₛₜₑᵣ 1241, 1147 cm⁻¹). The carbonyl (C=O) stretching peak maximum at 1726 cm⁻¹ experienced a shift to a lower wavenumber (4 cm⁻¹) compared to the undegraded organogel. More importantly, the C=O peak broadened strongly, which could indicate the presence of different carbonyls (e.g. ketones, aldehydes, esters), whose peaks overlap with the ester groups in poly(BMA-*co*-LMA-*co*-PPGDMA). The broad band between ca. 3500 cm⁻¹ to 2500 cm⁻¹ was attributed to different OH species, such as carboxylic acids, hydroxyl, or peroxide functionalities.
Figure 9:

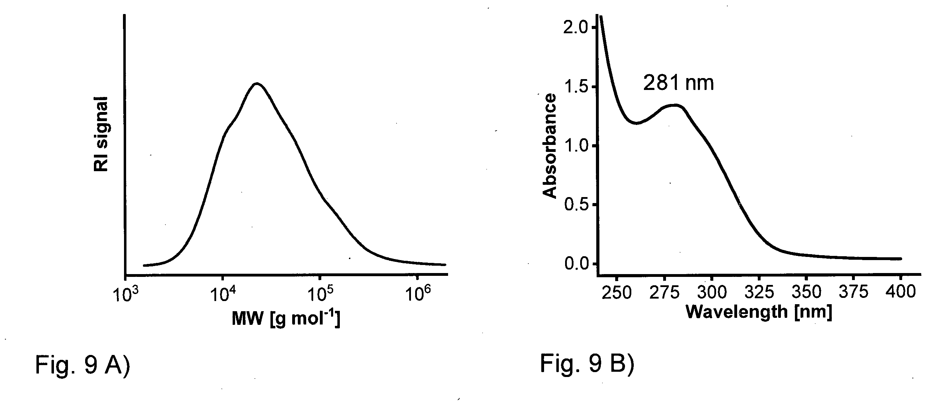

   Figure 9 A) shows SEC (size exclusion chromatography) traces of a photodegraded poly(BMA-*co*-LMA-*co*-PPGDMA) organogel irradiated for 30 min. The degraded organogel solution was precipitated in cold methanol, dried, dissolved in THF (2 mg l⁻¹), and filtered before injection into the SEC. Mₙ= 18.800 g mol⁻¹, M_{w} = 52.500 g mol⁻¹, Ð = 2.80.
   Figure 9 B) shows an UV-Vis spectrum of a poly(BMA-*co*-LMA-*co-*PPGDMA) organogel photodegraded for 30 min. The degraded organogel was diluted with MeCN to obtain a reliable spectrum (i.e. the local absorption maximum had an absorbance of less than 1.5). In contrast to the unirradiated organogel, an absorbance maximum at 281 nm was found. This indicated the presence of n-n* electron transitions and thus indicated the formation of functional groups such as aldehydes or formates (esters of formic acid) as products of the photodegradation. This finding hinted towards involvement of molecular oxygen from air. Such photooxidation processes were reported for poly(alkyl methacrylate) polymers (including poly(butyl methacrylate)) before.

### Examples:

Organogels were synthesized via Radical Polymerization using a 1:1 vol% mixture of butyl methacrylate (BMA) and lauryl methacrylate (LMA) as monomers and poly(propylene) glycol dimethacrylate (PPGDMA) as cross-linker in 1-nonanol as organic solvent.

### Example 1:

### Synthesis of poly(BMA-co-LMA-co-PPGDMA) organogel films and bulk materials:

All chemicals were purchased from Merck (Darmstadt, Germany) and used as delivered. Inhibitors were removed from the monomer and cross-linker by filtration through basic alumina. Precursor solutions were prepared from 2 ml (1.73 g) lauryl methacrylate (LMA), 2 ml (1.79 g) butyl methacrylate (BMA) and 8 ml (6.58 g) 1-nonanol or 1-butanol, respectively. As radical initiator, 40 mg of Azobisisobutyronitrile (AIBN) and 110 mg of poly(propylene glycol) dimethacrylate (PPGDMA) cross-linker were added and the resulting mixture was warmed to ca. 30 °C and agitated to ensure quantitative dissolution of AIBN. The resulting mixture was distributed into different reactions vessels. Reactions were carried out at 80 °C in an oven for 6 h. Depending on the targeted shape of the organogel, the polymerization was carried out in 20 ml vials for disc shaped gels and in a Teflon mold covered with glass for cuboid gels. The largest organogel was prepared in a petridish (d = 5 cm) using 10 ml of organogel precursor solution. After swelling, the diameter increased to 7 cm. Organogel films were prepared by pipetting 200 µl of organogel precursor solution onto a glass slide. The polymerization time for the production of an organogel film was shorter than for the preparation of a disc shaped gel performed in a vial. In a vial a certain volume of air reacts with the radicals formed by the decomposition of the initiator AIBN which quenches propagating radicals. For the preparation of the organogel film it is supposed that the amount of reacting air is lower.

### Example 2:

Influence of the degree of swelling on the photodegradation rate:
To test the influence of the degree of swelling on the photodegradation rate, poly(BMA-*co*-LMA-*co*-PPGDMA) organogel photoresists, prepared according to example 1, were swollen in excess 1-nonanol for different times (0, 6, and 48 h) to obtain gels with a different content of 1-nonanol (60.7, 67.5, and 76.3 wt%, respectively). The organogels were then irradiated with UV light for different exposure times and the weight of the degraded organogels relative to their initial weight was determined (Figure 4 A)). By normalizing the weight loss of the organogels to their initial weight the deviations in absolute mass of the organogels could be neglected. To ensure comparable results, the irradiated surface area of organogels was kept the same. It was observed that the rate of photodegradation increased with increasing 1-nonanol content (Figure 4 A)). For example, after 30 min of irradiation 87 wt% of organogels swollen for 0 h (60.7 wt% 1-nonanol) remained, whereas organogels swollen for 48 h (76.3 wt%) were fully degraded into a polymer solution, i.e. a liquefied organogel. GPC traces of such a liquified organogel revealed a monomodal distribution of polymer fragments with molecular weights between 10⁴ - 10⁵ g mo1⁻¹ as the photodegradation products (Figure 9 A)). These photodegradation products were separated from 1-nonanol by precipitation into cold methanol and further analyzed with ATR-FTIR (Figure 8) and UV-Vis spectroscopy (Figure 9 B). To clarify the influence of the UV absorbance and swelling factor of the solvent, the same procedure was pursued with organogels immersed into an excess of toluene, butanol, or PDMS 0.1 cm²/s 0 cSt) for 48 h, respectively (Figure 4 B)). Toluene and PDMS were chosen as model solvents to represent a high transmission but low swelling (PDMS) and a low transmission but high swelling solvent (toluene).

Toluene had the highest swelling factor (15.88 ± 0.37) but no detectable UV transmission below 280 nm, whereas PDMS possesses a negligible UV absorbance but a very low swelling factor (1.02 ± 0.01) (table 1). Interestingly, neither the toluene infused organogel nor the PDMS infused organogel showed photodegradation after up to 20 min irradiation time. In contrast, organogels infused with 1-butanol showed an even faster photodegradation than those infused with 1-nonanol, which could be attributed to the lower UV absorbance of 1-butanol compared to 1-nonanol. In conclusion, an ideal solvent for the photodegradation of organogels can swell the organogel network strongly whilst being highly transparent for UV light. If only one of these conditions was fulfilled, it could not compensate the other requirement, as shown by the failure of organogels swollen in toluene or PDMS to photodegrade (Figure 4 B)).

### Example 3:

### Swelling properties:

Poly(BMA-*co*-LMA-*co*-PPGDMA) organogels were swollen in excess n-hexane overnight. Excess liquid was removed by filtration. This was repeated three times. Then, n-hexane was removed from the polymeric network by drying the organogel in a fume hood for 60 min and then in an oven at 80 °C overnight. Poly(BMA-*co*-LMA-*co-*PPGDMA)organogels were then immersed into an excess of a certain solvent for at least 48 h and their respective swelling constants were determined as *swelling constant = weight_{swollen}*/*weight-dry .*

### Example 4:

### Photolithography of organogels:

Poly(BMA-*co*-LMA-*co*-PPGDMA) organogels were synthesized according to example 1 and swollen in the respective solvent. Gels were placed onto a glass plate and a photomask was placed on top of the organogel photoresist. UV irradiation was then carried out for defined times. The light intensity was kept constant and was monitored with a UVA and UVC sensor from Dr. Hoenle AG (Gräfelfing, Germany). After irradiation, the organogel photoresist was briefly rinsed with water and then carefully blow dried to remove excess solvent.

### Methods

### ATR-FTIR:

ATR-FTIR spectra were recorded with a Bruker Tensor 27 spectrometer from Bruker (Billerica, USA). A 45° geometry with a diamond crystal (single reflection) was used. Poly(BMA-*co*-LMA-*co-*PPGDMA) organogels were pressed tightly on the ATR crystal to ensure full surface contact. Photodegraded organogels were precipitated in cold methanol and extracted by centrifugation for 5 min at 1000 rpm in a 15 ml Falcon tube. The precipitate was dissolved in THF and then drop casted onto a glass plate. THF was removed in an oven at 80 °C overnight. This was repeated several times until a thick polymer layer had formed on the glass. The polymer layer was then tightly pressed onto the ATR crystal.

### GPC (Gel permeation chromatography):

Organogels pieces were photodegraded for 30 min. The resulting solution was taken up with a pipette and the polymer was precipitated in cold methanol. The suspension was then centrifuged for 5 min at 1000 rpm in a 15 ml Falcon Tube, and the precipitate was collected by filtration. The precipitate was dissolved in THF (ca. 2 mg ml⁻¹), filtered through 0.43 µm PTFE filters and injected in a Tosoh EcoSEC GPC system from Tosoh (Tokio, Japan) equipped with a SDV 5 µm bead size guard column (50 × 8 mm) followed by three SDV 5 µm columns (300 × 7.5 mm, subsequently 100, 1000 and 105 Å pore size, PSS), a differential refractive index (DRI) detector, and a UV-Vis detector set to 254 nm. THF was used as eluent at 35 °C with a flow rate of 1.0 ml·min⁻¹. The SEC system was calibrated using linear poly(methyl methacrylate) standards ranging from 800 to 1.82 × 10⁶ g mo1⁻¹.

### Microscopy:

Images were recorded on a Keyence BZ 9000 from Keyence (Osaka, Japan).

### Optical Profilometer:

For profilometry measurements, the 3D-Profilometer VR-5200 from Keyence (Osaka, Japan) was used. The organogels had to be treated with chalk spray to generate a thin, non-transparent surface prior to the measurements.

### UV lamp:

Photolithograhy was done using a UVA cube 2000 from Hönle (Gräfelfing, Germany). The device was used at 50% power.

### UV-Vis:

Spectra were recorded with a PerkinElmer Lambda 35 UV/VIS spectrometer from PerkinElmer Ink. (Waltham, USA). Organogel films (125 pm) were measured on a quartz glass slide against air as background. Photodegraded organogels were taken up with a pipette and measured in a quartz glass cuvette against HPLC grade water as reference.

## Claims

1. Method for the photolithographic preparation of a circuit board using a photoresist based on poly((meth)acrylate) organogels, comprising the following steps
A) Providing at least one alkyl (meth)acrylate, an aliphatic alcohol with a carbon chain length from C4 - C10 or an *n-*alkane with a carbon chain length from C8 - C12 as organic solvent, a radical initiator and a cross-linker;
B) Preparing a reaction mixture with the reactants and the solvent from step A) by mixing the least one alkyl (meth)acrylate with the aliphatic alcohol or the *n*-alkane, and adding to this mixture the radical initiator and the cross-linker;
C) Applying the reaction mixture from step B) to a surface of a substrate, wherein the surface carries a conductor layer.
D) Initiating the formation of radicals and (co)polymerization of the alkyl (meth)acrylate monomers under supply of heat, near-infrared (NIR) or ultraviolet-visible (UV-Vis) radiation onto the surface of the substrate from step C);
E) Placing a photomask on top of the photoresist from step D);
F) Irradiating the photomask from step E) with UV light;
G) Removing the photomask after step F) and rinsing the substrate with water or an organic solvent such as methanol or ethanol;
H) Etching the substrate after step G) in an etching solution or etching the surface of the substrate by plasma etching;
I) Removing the remaining organogel photoresist after step H) by irradiation with UV light or mechanical abrasion and exposing a conductor track.

2. Method according to claim 1, wherein in step A) is provided at least one medium-chain alkyl (meth)acrylate and at least one small-chain alkyl (meth)acrylate.

3. Method according to claim 2, wherein the at least one medium-chain alkyl (meth)acrylate is chosen from hexyl (meth)acrylate, heptyl (meth)acrylate, octyl (meth)acrylate, nonyl (meth)acrylate, decyl (meth)acrylate, undecyl (meth)acrylate, dodecyl (meth)acrylate (lauryl (meth)acrylate), tridecyl (meth)acrylate, tetradecyl (meth)acrylate, pentadecyl (meth)acrylate or hexadecyl (meth)acrylate and the at least one small-chain alkyl (meth)acrylate is chosen from methyl (meth)acrylate, ethyl (meth)acrylate, propyl (meth)acrylate, isopropyl (meth)acrylate, butyl (meth)acrylate, isobutyl (meth)acrylate, *tert*-butyl (meth)acrylate or pentyl (meth)acrylate.

4. Method according to one of the preceding claims, wherein in steps A) the organic solvent is chosen from 1-butanol, *tert-*butanol, 1-pentanol, 1-hexanol, 1-heptanol, 1-octanol, 1-nonanol or the organic solvent is chosen from 1-nonane, 1-decane or 1-undecane.

5. Method according to one of the preceding claims, wherein in step A) the cross-linker is selected from poly(propylene) glycol dimethacrylate (PPGDMA), ethylene glycol dimethacrylate (EGDMA), N,N'-methylenebisacrylamide (MBAA), poly(ethylene glycol) dimethacrylate and poly(ethylene glycol) diacrylate.

6. Method according to one of the preceding claims, wherein the mole fraction of the cross-linker used is from 0.10 to 20 % based on the total amount of the monomer units and the cross-linker.

7. Method according to one of the preceding claims, wherein in step A) the radical initiator is chosen from azo compounds.

8. Method according to one of the preceding claims, wherein the substrate in step C) is chosen from glass, quartz, alcohol resistant thermosets, polyimides, glass-epoxy composites or phenolic paper.

9. Method according to one of the preceding claims, wherein the conductor layer in step C) comprises at least one metal, polysilicon or at least one semiconductor material.

10. Method according to claim 9, wherein the at least one metal is chosen from Cu, Ni, Ag, Au, Cr, Mo or Al or the at least one semiconductor material is chosen from silicon-germanium, gallium arsenide or gallium nitride.

11. Method according to one of the preceding claims, wherein the conductor layer has a thickness of 17.5 - 70 µm.

12. Method according to one of the preceding claims, wherein in step D) the mixture is heated to 60 - 80 °C for 30 - 90 min or is irradiated with UV-Vis light with a wavelength of 360 - 380 nm and an intensity from 1 mW/cm² to 10 mW/cm² for 1 - 10 min.

13. Method according to one of the preceding claims, wherein after step D) the organogel photoresist is swollen before the photodegradation on the substrate in an aliphatic alcohol with a carbon chain length from C4 - C10 or in an n-alkane with a carbon chain length from C8 - C12 as organic solvent, wherein the solvent chosen is the same as the solvent chosen in step A).

14. Method according to claim 13, wherein the content of the organic solvent in the swollen organogel photoresist is from 60 to 90 wt%.

15. Method according to one of the preceding claims, wherein in steps F) and I) the UV irradiation has a wavelength of 190 - 320 nm, an intensity from 10 mW/cm² to 20 mW/cm² and a duration of 1 - 10 min.

## Patentansprüche

1. Verfahren zur photolithographischen Herstellung einer Leiterplatte mittels eines Photolacks auf der Basis von Poly((meth)acrylat)-Organogelen, umfassend die Schritte
A) Bereitstellen mindestens eines Alkyl(meth)acrylats, eines aliphatischen Alkohols mit einer Kohlenstoffkettenlänge von C4 - C10 oder eines n-Alkans mit einer Kohlenstoffkettenlänge von C8 - C12 als organisches Lösungsmittel, eines Radikalstarters und eines Vernetzers;
B) Herstellen einer Reaktionsmischung mit den Edukten und dem Lösungsmittel aus Schritt A) durch Mischen des mindestens einen Alkyl(meth)acrylats und des aliphatischen Alkohols oder des n-Alkans und Hinzufügen des Radikalstarters und des Vernetzers zu der Mischung;
C) Aufbringen der Reaktionsmischung aus Schritt B) auf eine Oberfläche eines Substrats, wobei die Oberfläche eine Leitschicht trägt;
D) Initiieren der Radikalbildung und (Co)polymerisation der Alkyl(meth)acrylatmonomere unter Zufuhr von Wärme, Nahinfrarot- (NIR) oder Ultraviolett-sichtbarer (UV-Vis) Strahlung auf die Oberfläche des Substrats aus Schritt C) ;
E) Auflegen einer Photomaske auf den Photolack aus Schritt D) ;
F) Bestrahlen der Photomaske aus Schritt E) mittels UV-Licht;
G) Entfernen der Photomaske nach Schritt F) und Spülen des Substrats mit Wasser oder einem organischen Lösungsmittel wie Methanol oder Ethanol;
H) Ätzen des Substrats nach Schritt G) in einer Ätzlösung oder Ätzen der Oberfläche des Substrats durch Plasma-Ätzen;
I) Entfernen des restlichen Organogel-Photolacks nach Schritt H) durch Bestrahlung mit UV-Licht oder mechanischen Abrieb und Freilegen einer Leiterbahn.

2. Verfahren nach Anspruch 1, wobei in Schritt A) mindestens ein mittelkettiges Alkyl(meth)acrylat und mindestens ein kleinkettiges Alkyl(meth)acrylat bereitgestellt wird.

3. Verfahren nach Anspruch 2, wobei das mindestens eine mittelkettige Alkyl(meth)acrylat ausgewählt ist aus Hexyl(meth)acrylat, Heptyl(meth)acrylat, Octyl(meth)acrylat, Nonyl(meth)acrylat, Decyl(meth)acrylat, Undecyl(meth)acrylat, Dodecyl(meth)acrylat (Lauryl(meth)acrylat), Tridecyl(meth)acrylat, Tetradecyl(meth)acrylat, Pentadecyl(meth)acrylat oder Hexadecyl(meth)acrylat und das mindestens eine kleinkettige Alkyl(meth)acrylat ausgewählt ist aus Methyl(meth)acrylat, Ethyl(meth)acrylat, Propyl(meth)acrylat, Isopropyl(meth)acrylat, Butyl(meth)acrylat, Isobutyl(meth)acrylat, *tert*-Butyl(meth)acrylat und Pentyl(meth)acrylat.

4. Verfahren nach einem der vorhergehenden Ansprüche, wobei in Schritt A) das organische Lösungsmittel ausgewählt ist aus 1-Butanol, tert-Butanol, 1-Pentanol, 1-Hexanol, 1-Heptanol, 1-Octanol, 1-Nonanol oder das organische Lösungsmittel ausgewählt ist aus 1-Nonan, 1-Dekan oder 1-Undekan.

5. Verfahren nach einem der vorhergehenden Ansprüche, wobei in Schritt A) der Vernetzer ausgewählt ist aus Poly(propylenglycoldimethacrylat (PPGDMA), Ethylenglycoldimethacrylat (EGDMA), N,N'-Methylenbisacrylamid (MBAA), Poly(ethylenglycol)dimethacrylat und Poly(ethylenglycol)-diacrylat.

6. Verfahren nach einem der vorhergehenden Ansprüche, wobei der Stoffmengenanteil des verwendeten Vernetzers 0,10 bis 20 % beträgt, bezogen auf die Gesamtmenge der Monomereinheiten und des Vernetzers.

7. Verfahren nach einem der vorhergehenden Ansprüche, wobei in Schritt A) der Radikalstarter aus Azoverbindungen ausgewählt ist.

8. Verfahren nach einem der vorhergehenden Ansprüche, wobei das Substrat in Schritt C) aus Glas, Quarz, alkoholbeständigen Duroplasten, Polyimiden, Glas-Epoxid-Verbundwerkstoffen oder Phenolpapier ausgewählt ist.

9. Verfahren nach einem der vorhergehenden Ansprüche, wobei die Leitschicht in Schritt C) mindestens ein Metall, Polysilizium oder mindestens ein Halbleitermaterial umfasst.

10. Verfahren nach Anspruch 9, wobei das mindestens eine Metall ausgewählt ist aus Cu, Ni, Ag, Au, Cr, Mo oder Al oder das mindestens eine Halbleitermaterial ausgewählt ist aus Siliziumgermanium, Galliumarsenid oder Galliumnitrid.

11. Verfahren nach einem der vorhergehenden Ansprüche, wobei die Leitschicht eine Dicke von 17,5 - 70 µm aufweist.

12. Verfahren nach einem der vorhergehenden Ansprüche, wobei in Schritt D) die Mischung für 30 - 90 min auf 60 - 80 °C erhitzt oder mit UV-Vis-Licht mit einer Wellenlänge von 360 - 380 nm und einer Intensität von 1 mW/cm² bis 10 mW/cm² für 1 - 10 min bestrahlt wird.

13. Verfahren nach einem der vorhergehenden Ansprüche, wobei nach Schritt D) der Organogel-Photolack vor der Photodegradation auf dem Substrat in einem aliphatischen Alkohol mit einer Kohlenstoffkettenlänge von C4 - C10 oder in einem n-Alkan mit einer Kohlenstoffkettenlänge von C8 - C12 als organisches Lösungsmittel aufgequollen wird, wobei das gewählte Lösungsmittel das Gleiche ist wie das in Schritt A) ausgewählte Lösungsmittel.

14. Verfahren nach Anspruch 13, wobei der Gehalt des organischen Lösungsmittels in dem aufgequollenen Organogel-Photolack 60 bis 90 Gew.-% beträgt.

15. Verfahren nach einem der vorhergehenden Ansprüche, wobei in den Schritten F) und I) die UV-Bestrahlung eine Wellenlänge von 190 - 320 nm, eine Intensität von 10 mW/cm² bis 20 mW/cm² und eine Dauer von 1 - 10 min aufweist.

## Revendications

1. Procédé de fabrication photolithographique d'une carte de circuit imprimé utilisant une résine photosensible à base d'organogels de poly((méth)acrylate), comprenant les étapes suivantes :
A) se procurer au moins un (méth)acrylate d'alkyle, un alcool aliphatique avec une longueur de chaîne carbonée de C4 - C10 ou un n-alcane avec une longueur de chaîne carbonée de C8 - C12 comme solvant organique, un initiateur de radicaux et un agent réticulant ;
B) préparer un mélange réactionnel avec les réactifs et le solvant de l'étape A) en mélangeant l'au moins un (méth)acrylate d'alkyle avec l'alcool aliphatique ou le n-alcane, et en ajoutant à ce mélange l'initiateur de radicaux et le réticulant ;
C) appliquer le mélange réactionnel de l'étape B) à la surface d'un substrat, la surface portant une couche conductrice ;
D) initier la formation de radicaux et (co)polymérisation des monomères de (méth)acrylate d'alkyle avec l'apport de chaleur, d'un rayonnement proche infrarouge (NIR) ou ultraviolet-visible (UV-Vis) sur la surface du substrat de l'étape C) ;
E) placer un masque photographique au-dessus de la résine photosensible de l'étape D) ;
F) irradier le masque photographique de l'étape E) avec de la lumière UV ;
G) retirer le masque photographique après l'étape F) et rincer le substrat avec de l'eau ou un solvant organique tel que le méthanol ou l'éthanol ;
H) graver le substrat après l'étape G) dans une solution de gravure ou graver la surface du substrat par gravure plasma ;
I) retirer la résine photosensible à base d'organogels restante après l'étape H) par irradiation à la lumière UV ou abrasion mécanique et révéler une piste conductrice.

2. Procédé selon la revendication 1, selon lequel l'étape A) fournit au moins un (méth)acrylate d'alkyle à chaîne moyenne et au moins un (méth)acrylate d'alkyle à petite chaîne.

3. Procédé selon la revendication 2, selon lequel l'au moins un (méth)acrylate d'alkyle à chaîne moyenne est choisi parmi le (méth)acrylate d'hexyle, le (méth)acrylate d'heptyle, le (méth)acrylate d'octyle, le (méth)acrylate de nonyle, le (méth)acrylate de décyle, le (méth)acrylate d'undécyle, le (méth)acrylate de dodécyle (le (méth)acrylate de lauryl), le (méth)acrylate de tridécyle, le (méth)acrylate de tétradécyle, le (méth)acrylate de pentadécyle ou le (méth)acrylate d'hexadécyle, et l'au moins un (méth)acrylate d'alkyle à petite chaîne est choisi parmi le (méth)acrylate de méthyle, le (méth)acrylate d'éthyle, le (méth)acrylate de propyle, le (méth)acrylate d'isopropyle, le (méth)acrylate de butyle, le (méth)acrylate d'isobutyle, le (méth)acrylate de tert-butyle ou le (méth)acrylate de pentyle.

4. Procédé selon l'une des revendications précédentes, selon lequel dans l'étape A), le solvant organique est choisi parmi le 1-butanol, le *tert*-butanol, le 1-pentanol, le 1-hexanol, le 1-heptanol, le 1-octanol, le 1-nonanol ou le solvant organique est choisi parmi le 1-nonane, le 1-décane ou le 1-undécane.

5. Procédé selon l'une des revendications précédentes, selon lequel dans l'étape A) l'agent réticulant est choisi parmi le poly(propylène) glycol diméthacrylate (PPGDMA), l'éthylène glycol diméthacrylate (EGDMA), le N,N'-méthylènebisacrylamide (MBAA), le poly(éthylène glycol) diméthacrylate et le poly(éthylène glycol) diacrylate.

6. Procédé selon l'une des revendications précédentes, selon lequel la fraction molaire de l'agent réticulant utilisé est de 0,10 à 20 % par rapport à la quantité totale d'unités monomères et de l'agent réticulant.

7. Procédé selon l'une des revendications précédentes, selon lequel dans l'étape A), l'initiateur de radicaux est choisi parmi les composés azo.

8. Procédé selon l'une des revendications précédentes, selon lequel le substrat de l'étape C) est choisi parmi le verre, le quartz, les thermodurcissables résistant à l'alcool, les polyimides, les composites verre-époxy ou le papier phénolique.

9. Procédé selon l'une des revendications précédentes, selon lequel la couche conductrice de l'étape C) comprend au moins un métal, du polysilicium ou au moins un matériau semi-conducteur.

10. Procédé selon la revendication 9, selon lequel l'au moins un métal est choisi parmi Cu, Ni, Ag, Au, Cr, Mo ou Al ou l'au moins un matériau semi-conducteur est choisi parmi le silicium-germanium, l'arséniure de gallium ou le nitrure de gallium.

11. Procédé selon l'une des revendications précédentes, selon lequel la couche conductrice a une épaisseur comprise entre 17,5 et 70 µm.

12. Procédé selon l'une des revendications précédentes, selon lequel dans l'étape D), le mélange est chauffé à 60 - 80 °C pendant 30 - 90 minutes ou est irradié par une lumière UV-Vis d'une longueur d'onde de 360 - 380 nm et d'une intensité de 1 mW/cm² à 10 mW/cm² pendant 1 - 10 minutes.

13. Procédé selon l'une des revendications précédentes, dans lequel, après l'étape D), la résine photosensible à base d'organogels est gonflée avant la photodégradation sur le substrat dans un alcool aliphatique avec une longueur de chaîne carbonée de C4 - C10 ou dans un n-alcane avec une longueur de chaîne carbonée de C8 - C12 en tant que solvant organique, le solvant choisi étant le même que le solvant choisi dans l'étape A).

14. Procédé selon la revendication 13, selon lequel la teneur en solvant organique de la résine photosensible à base d'organogels gonflée est comprise entre 60 et 90 % en poids.

15. Procédé selon l'une des revendications précédentes, selon lequel dans les étapes F) et I), le rayonnement UV a une longueur d'onde de 190 - 320 nm, une intensité de 10 mW/cm² à 20 mW/cm² et une durée de 1 - 10 min.
